# EUROPÄISCHE PATENTSCHRIFT

(11) **EP 0 728 952 B1**
(45) Veröffentlichungstag und Bekanntmachung des Hinweises auf die Patenterteilung: **25.11.1998**
(21) Anmeldenummer: 96101683.9
(22) Anmeldetag: 06.02.1996
(51) Int. Cl.: F16B 21/02, H02G 3/14

(54) **Klemmverbindung, insbesondere zur Festlegung von Gehäuseteilen elektrischer Geräte, und Verschlusselement dafür**
Clamping connection especially for the locking of housing parts for electric devices and locking element therefore
Connexion par serrage pour la fixation d'éléments de boîtiers d'appareils électriques et élément de fermeture pour sa mise en oeuvre

(30) Priorität: 21.02.1995 DE 19505986
(43) Veröffentlichungstag der Anmeldung: 28.08.1996
(73) Patentinhaber: Siemens Nixdorf Informationssysteme AG, 33106 Paderborn (DE)
(72) Erfinder: Klauss, Helmut, Dipl.-Ing. (FH), D-86157 Augsburg (DE); Seidel, Bernd, Dipl.-Ing. (TU), D-08209 Auerbach (DE)
(74) Vertreter: Epping, Wilhelm, Dr.-Ing.

(56) Entgegenhaltungen:
- EP-A- 0 636 798
- DE-A- 3 517 121
- GB-A- 2 257 461
- US-A- 3 417 442
- US-A- 4 653 970
- IBM TECHNICAL DISCLOSURE BULLETIN, Bd. 35, Nr. 6, 1.November 1992, ARMONK, NY, (US), Seiten 129-130, XP000314084 "FASTENING SYSTEM"

## Beschreibung

Die Erfindung betrifft eine Klemmverbindung zum spielfreien Festlegen eines ersten Teiles an einem zweiten Teil, insbesondere von Gehäuseteilen elektrischer Geräte entsprechend dem Oberbegriff des Anspruches 1.

Klemmverbindungen zur Festlegung zweier Teile aneinander sind in vielfältiger Form allgemein bekannt. Bei Verwendung von Haken und Schnappern ist ein spielfreies Festlegen bei gleichzeitigem Toleranzausgleich kaum möglich, insbesondere können die Teile nicht gegeneinander verspannt werden. Viele benötigen gesonderte Werkzeuge zur Herstellung oder zum Lösen einer solchen Verbindung. Ähnliches gilt auch für eine Anordnung gemäß dem Oberbegriff des Anspruches 1, die durch die europäische Patentanmeldung 0 636 798 A2 bekannt ist. Das Verschlußelement ähnelt dabei einer Zylinderkopfschraube, wobei zwischen Schraubenkopf und der Außenfläche des ersten Teiles eine Schraubfeder wirksam ist und eine Spannkraft senkrecht zur Auflagefläche der beiden Teile erzeugt. Diese Art der Klemmverbindung ermöglicht ebenfalls kein spielfreies Verspannen beider Teile. Auch wird zur Herstellung und zum Lösen der Klemmverbindung ein Werkzeug benötigt. Bei elektrischen Geräten, die beispielsweise aus einer Wanne und einem aufschiebbaren bzw. aufsetzbaren Deckel mit anhängender Frontplatte oder einer entsprechenden Haube bestehen, ist es beispielsweise erforderlich, daß die Haube auf der Wanne im geschlossenen Zustand des Gerätes spielfrei in einer definierten Lage festgelegt werden kann.

Gegenstand der Erfindung ist daher eine Klemmverbindung, die ein spielfreies Festlegen zweier Teile, insbesondere von Gehäuseteilen irgendwelcher Geräte, und ein Lösen ohne Gefahr von Beschädigungen und ohne Werkzeug ermöglicht, und ein dafür geeignetes Verschlußelement, das als integraler Bestandteil der Klemmverbindung gleichzeitig die Funktion eines Werkzeugs übernimmt.

Eine Klemmverbindung, die diese Eigenschaften aufweist, ergibt sich aus den Merkmalen des Anspruches 1. Kernstück der neuen Klemmverbindung ist dabei, daß das die festzulegenden Teile durchdringende drehbare Verschlußelement neben den Ansätzen zum Hintergreifen des einen Teiles einen zusätzlichen Exzenteransatz aufweist, der in Verbindung mit einem Federelement eine Spannfunktion gegenüber einem vorgegebenen Anschlag ausübt und so ein spielfreies Festlegen ermöglicht.

Das Federelement besteht zweckmäßig aus einer Federstange, die in alle Richtungen hin auslenkbar ist. Der Drehwinkel zwischen Entriegelungsstellung und Verschlußstellung beträgt vorzugsweise 90°.

Die Gestaltung des zugehörigen Verschlußelementes ergibt sich aus den Merkmalen des Anspruches 4. Es besteht danach im wesentlichen aus einem Ringteil zum Halten und Führen am ersten Teil der Klemmverbindung und einem daran angeformten Hohlkörper als Träger der Ansätze zum Hintergreifen des zweiten Teiles und des Exzenteransatzes, wobei der Hohlkörper gleichzeitig als Griffmulde dient, so daß ein Drehen ohne gesondertes Werkzeug trotz der Federbelastung möglich ist.

Vorteilhafte Weiterbildungen des Verschlußelementes ergeben sich aus den Ansprüchen 5 und 6.

Einzelheiten der Erfindung seien nachfolgend anhand eines in der Zeichnung dargestellten Ausführungsbeispieles erläutert. Im einzelnen zeigen
- FIG 1: ein Gerät in auseinandergezogener perspektivischer Darstellung,
- FIG 2: die am Gerät von FIG 1 vorgesehene Klemmverbindung gemäß der Erfindung aus der Sicht des Geräteinneren mit einer Schnittdarstellung entlang der Schnittlinie A-A,
- FIG 3: eine Seitenansicht des Verschlußelementes entsprechend der Sicht B-B von FIG 2 und
- FIG 4 und FIG 5: perspektivische Darstellungen des Verschlußelementes.

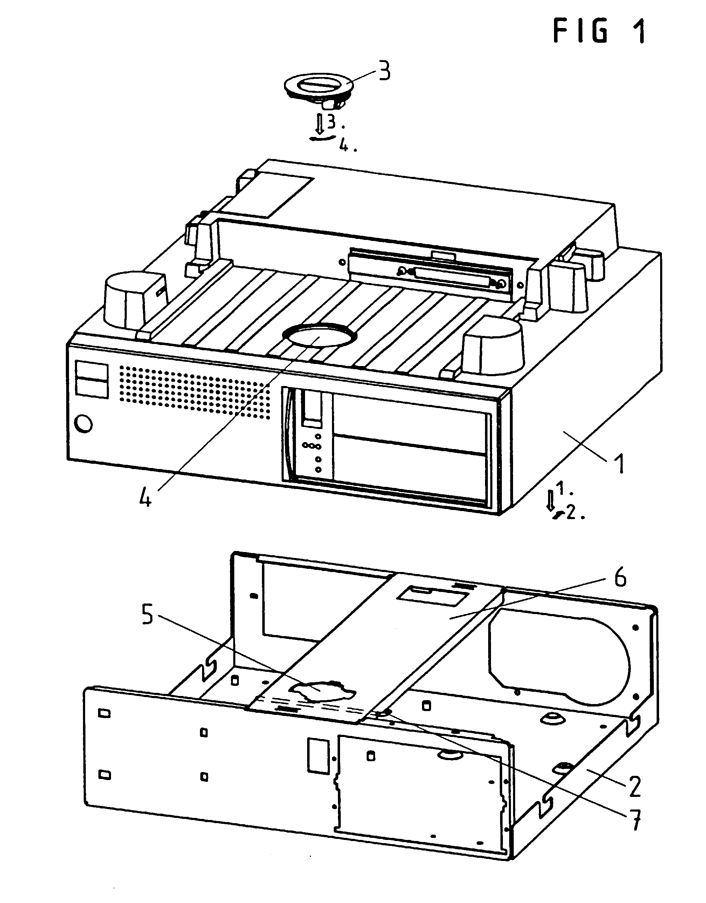

Bei dem in FIG 1 dargestellten Gerät handelt es sich beispielsweise um einen Personalcomputer mit einer Wanne als zweitem Teil 2 und einem auf diese aufsetzbaren oder aufschiebbaren Deckel mit anhängender Frontblende als erstes Teil 1, wobei der Deckel auf der Wanne in einer definierten Lage spielfrei gehalten werden soll. Hierzu dient ein von außen einsetzbares Verschlußelement 3, das in übereinanderliegende Aufnahmeöffnungen 4 bzw. 5 eingesetzt wird und durch Drehen um 90° beide Teile 1 und 2 gegeneinander spielfrei festlegt. Die Aufnahmeöffnung 5 von Teil 2 befindet sich beispielsweise auf einer gesonderten Traverse 6, die gleichzeitig als Halterung für eine mit dem Verschlußelement 3 zusammenwirkende Federstange 7 dient.

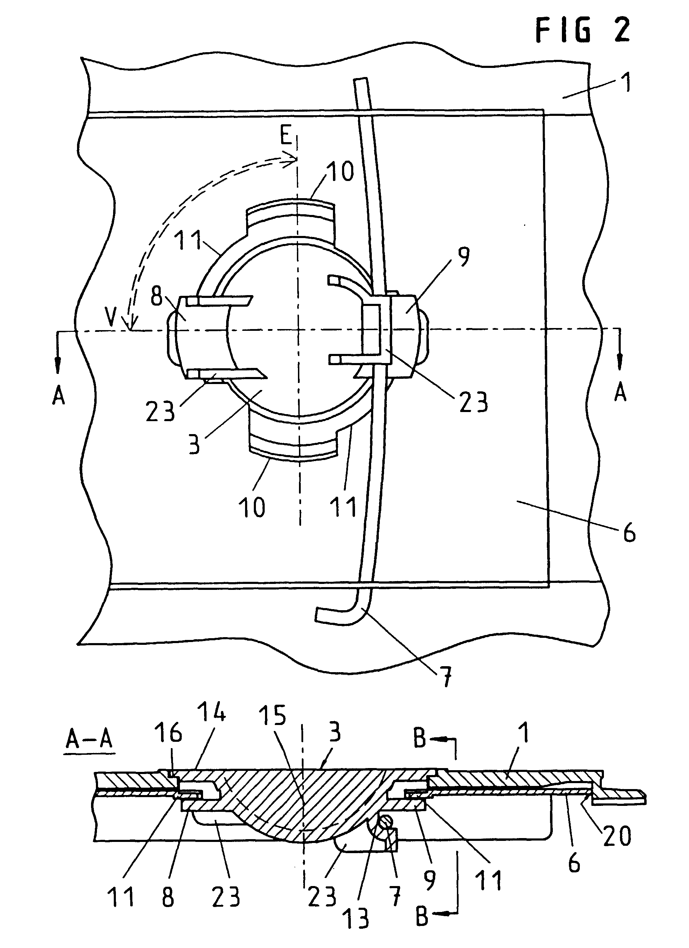

FIG 2 zeigt die Klemmverbindung, vom Inneren des Gerätes gemäß FIG 1 aus gesehen, in der Verschlußstellung V, d.h. mit um 90° gegenüber der Entriegelungsstellung E gedrehtem Verschlußelement 3. Erkennbar ist wiederum das erste Teil 1 mit der darunterliegenden Traverse 6 vom zweiten Teil 2 und der vom letzterer gehaltenen Federstange 7.

Das Verschlußelement 3 weist zwei einander gegenüberliegende Ansätze 8 und 9 auf, die durch die Entriegelungsstellung E bestimmende angepaßte Ausschnitte 10 der Aufnahmeöffnung 5 am zweiten Teil 2 beim Einsetzen des Verschlußelementes 3 unter die Traverse 6 gelangen und beim Drehen des Verschlußelementes 3 Abschnitte 11 der Traverse 6 hintergreifen. Über dem einen Ansatz 9 ist außerdem ein Exzenteransatz 12 am Verschlußelement 3 vorgesehen, der beim Drehen des Verschlußelementes 3 von der Entriegelungsstellung E aus in Richtung auf die Verschlußstellung V zu die Federstange 7 seitlich auslenkt und dann in eine einwärts gerichtete ebene Anlagefläche 13 für die Federstange überleitet, so daß ein Schnappeffekt zur Sicherung der Verschlußstellung V erzielt wird, gleichzeitig aber eine ausreichende, die spielfreie Festlegung der Teile 1 und 2 gewährleistende Spannkraft erhalten bleibt.

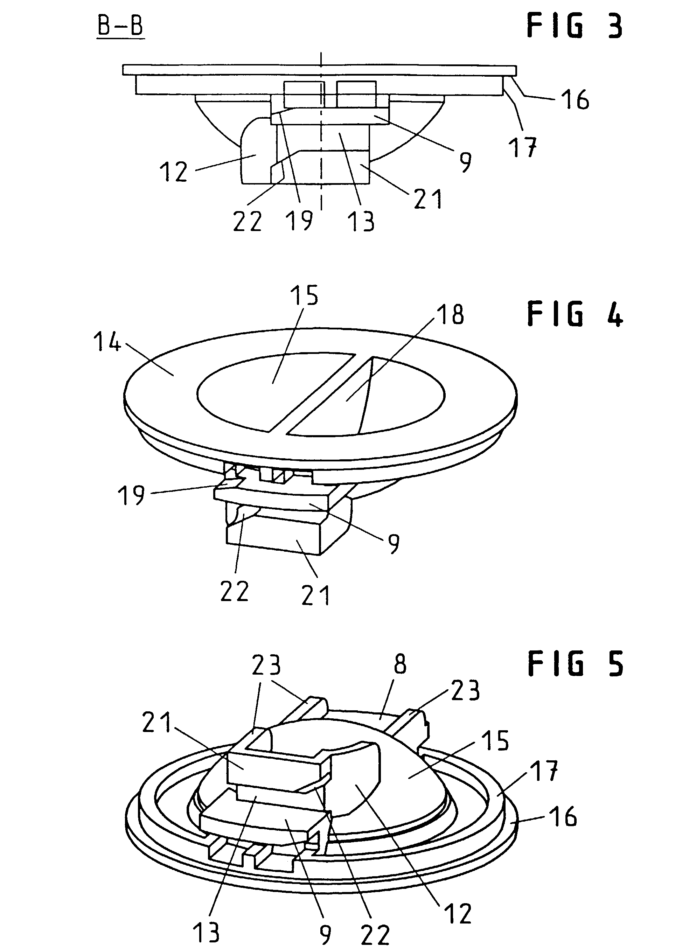

Wie aus dem zugehörigen Querschnitt entlang der Schnittlinie A-A weiterhin zu ersehen ist, besteht das Verschlußelement 3 aus einem Ringteil 14 mit angeformten Hohlkörper 15 als Griffmulde, an dessen Außenfläche die Ansätze 8 und 9 sowie der Exzenteransatz 12 mit der Anlagefläche 13 für die Federstange 7 angeformt sind, wie auch FIG 3 bis FIG 5 erkennen lassen. Die Darstellung von FIG 3 entspricht dabei der Seitenansicht entsprechend der Sicht B-B am Querschnitt A-A von FIG 2.

Das Ringteil 14 dient einerseits als äußere Halterung für das erste Teil 1 gegenüber dem zweiten Teil 2 und zum anderen als Führung in der Aufnahmeöffnung 4 des ersten Teiles 1. Zu diesem Zweck ist es mit einer der Außenseite des ersten Teiles 1 zugewandten ringförmigen Anschlagfläche 16 und einem nach Innen darin anschließenden Führungsring 17 mit kleinem Außendurchmesser versehen. Außerdem ist die Aufnahmeöffnung 4 des ersten Teiles 1 zweckmäßig mit einer versenkten Gegenanschlagfläche versehen, so daß - wie der Querschnitt A-A von FIG 2 zeigt - die Außenfläche des Verschlußelementes 3 bündig mit der Außenfläche des ersten Teiles 1 abschließt.

Wird also das in der Entriegelungsstellung E eingesetzte Verschlußelement 3, dessen Hohlkörper 15 als Griffmulde dient und gemäß FIG 4 mit einem diametral verlaufenden Griffsteg 18 versehen ist, in Richtung auf die Verschlußstellung V gedreht, dann werden die Teile 1 und 2 zwischen der Anschlagfläche 16 und den die Abschnitte 11 hintergreifenden Ansätzen 8 und 9 gehalten.

Um das Aufgleiten der Ansätze 8 und 9 auf die zu hintergreifenden Abschnitte 11 zu erleichtern, sind die Ansätze in Drehrichtung auf die Verschlußstellung V mit einer Aufgleitschräge 19 versehen, wobei nach Überwinden der Aufgleitschräge 19 das Auflagenspiel zwischen beiden Teilen 1 und 2 bei entsprechender Dimensionierung äußerst klein gehalten werden kann.

Außerdem wird durch Auslenken der Federstange 7 eine Kraft wirksam, die das Verschlußelement 3 und damit das erste Teil 1 gegenüber dem zweiten Teil 2 bis zum Erreichen eines vorgegebenen Anschlages verschiebt und somit mit Bezug auf FIG 1 die auf die Wanne als zweiter Teil 2 aufgesetzte Haube als erstes Teil 1 horizontal nach hinten drückt und damit spielfrei festlegt. Im Querschnitt A-A von FIG 2 wird der Anschlag durch die Vorderkante 20 der Traverse und damit der Frontseite des zweiten Teiles 2 gebildet.

Die Anlagefläche 13 für die Federstange 7 wird zweckmäßig durch einen sich radial erstreckenden und mit dem Ansatz 9 für das Hintergreifen eine Nut bildenden Ansatz 21 begrenzt, der wie der Ansatz 9 mit einer Aufgleitschräge 22 versehen ist. Auf diese Weise wird die Federstange 7 nicht nur durch den Exzenteransatz 12 mit der nachfolgenden Anlagefläche 13 in einer Richtung, sondern auch senkrecht dazu ausgelenkt, so daß das Verschlußelement 3 und damit das festzulegende erste Teil 1 durch die Federwirkung auch senkrecht gegen das zweite Teil 2 gedrückt wird. Dadurch ist in allen Richtungen ein größerer Toleranzausgleich möglich.

Abhängig vom gewählten Material für das Verschlußelement 3 können zusätzliche Versteifungsstege 23 an den einzelnen Ansätzen 8, 9 und 21 notwendig sein, um eine ausreichende Steifigkeit zu erreichen.

## Patentansprüche

1. Klemmverbindung zum spielfreien Festlegen eines ersten Teiles (1) an einem zweiten Teil (2), insbesondere von Gehäuseteilen elektrischer Geräte, mit einem in das erste Teil (1) von außen einsetzbaren und beide Teile (1, 2) durchdringenden, drehbaren Verschlußelement (3), das zwei gegenüberliegende und sich radial erstreckende Ansätze (8, 9) zum Hintergreifen von Abschnitten (11) des zweiten Teiles (2) bei einer Drehbewegung des Verschlußelementes (3) von einer das Einsetzen ermöglichenden Entriegelungsstellung (E) aus aufweist, **gekennzeichnet** durch ein am zweiten Teil (2) angebrachtes Federelement (Federstange 7) und einem am Verschlußelement (3) angebrachtem und auf das Federelement (7) einwirkenden Exzenteransatz (12) zur Erzeugung einer das erste Teil (1) spielfrei an einem Anschlag (20) des zweiten Teiles (2) festlegenden Spannkraft in einer vorgegebenen Drehendstellung des Verschlußelementes (3) als Verschlußstellung (V).

2. Klemmverbindung nach Anspruch 1,
**dadurch gekennzeichnet**, daß das Federelement aus einer an beiden Enden gehaltenen und durch den Exzenteransatz (12) auslenkbaren Federstange (7) besteht.

3. Klemmverbindung nach einem der Ansprüche 1 oder 2,
**dadurch gekennzeichnet**, daß der Drehwinkel zwischen der Entriegelungsstellung (E) und der Verschlußstellung (V) 90° beträgt.

4. Verschlußelement für Klemmverbindungen nach einem der Ansprüche 1 bis 3, bestehend aus einem Ringteil (14) mit einem als Griffmulde dienenden angeformten Hohlkörper (10), an dessen Außenfläche die Ansätze (8, 9) zum Hintergreifen des zweiten Teiles (2) und der Exzenteransatz (12) angeformt sind, wobei das Ringteil (14) eine der Außenseite des ersten Teiles (1) zugewandte ringförmige Anschlagfläche (16) und einen nach Innen sich daran anschließenden Führungsring (17) aufweist und die Ansätze (8, 9) zum Hintergreifen des zweiten Teiles (2) zusammen mit der innen liegenden Stirnseite des Führungsringes (17) am Ringteil (14) Nuten bilden, in die die zu hintergreifenden Abschnitte (11) des zweiten Teiles (2) beim Drehen des Verschlußelementes (3) in die Verschlußstellung (V) hineingleiten, und daß die dabei in Drehrichtung den Anfang der Nuten bildenden Teile der Innenflächen der Ansätze (8, 9) als Aufgleitschräge (19) ausgebildet sind.

5. Verschlußelement nach Anspruch 4,
**dadurch gekennzeichnet**, daß der Exzenteransatz (12) im Anschluß an den eine vorgegebene maximale Auslenkung des Federelementes (Federstange 7) bewirkenden Auslenkungspunkt in eine in Drehrichtung sich anschließende einwärtsgerichtete ebene Anlagefläche (13) für das Federelement in der Verschlußstellung (V) übergeht.

6. Verschlußelement nach Anspruch 5,
**dadurch gekennzeichnet**, daß die Anlagefläche (13) für das Federelement (Federstange 7) gegenüber einem der Ansätze (9) zum Hintergreifen angeordnet ist und durch einen sich radial erstreckenden und mit dem Ansatz (9) zum Hintergreifen eine Nut bildenden Ansatz (21) mit einer Aufgleitschräge (22) begrenzt wird, so daß das Federelement (7) auch senkrecht zur Auslenkrichtung durch den Exzenteransatz (12) auslenkbar ist.

## Claims

1. Clamping connection for securing a first part (1) on a second part (2), in particular housing parts of electric equipment, in a play-free manner, having a rotatable locking element (3), which can be inserted into the first part (1) from the outside, passes through the two parts (1, 2) and has two mutually opposite and radially running extensions (8, 9) for engaging behind sections (11) of the second part (2) when the closure element (3) is rotated from an unlocking position (E), in which insertion is permitted, characterized by a resilient element (resilient rod 7), which is provided on the second part (2), and an eccentric extension (12), which is provided on the locking element (3), acts on the resilient element (7) and is intended for producing a stressing force, securing the first part (1) on a stop (20) of the second part (2) in a play-free manner, in a predetermined rotary end position of the locking element (3), as locking position (V).

2. Clamping connection according to Claim 1, characterized in that the resilient element comprises a resilient rod (7) which is retained at both ends and can be deflected by the eccentric extension (12).

3. Clamping connection according to either of Claims 1 and 2, characterized in that the rotary angle between the unlocking position (E) and the locking position (V) is 90°.

4. Locking element for clamping connections according to one of Claims 1 to 3, comprising a ring part (14) with an integrally formed hollow body (10) which serves as a hollow grip and has integrally formed on its outer surface the eccentric extension (12) and the extensions (8, 9) for engaging behind the second part (2), it being the case that the ring part (14) has an annular stop surface (16), which is directed towards the outside of the first part (1), and a guide ring (17), which adjoins said stop surface towards the interior, and the extensions (8, 9) for engaging behind the second part (2) form, together with the inner end side of the guide ring (17) on the ring part (14), grooves into which the sections (11) of the second part (2), behind which the extensions (8, 9) are to engage, slide when the locking element (3) is rotated into the locking position (V), and those parts of the inner surfaces of the extensions (8, 9) which form the start of the grooves in the direction of rotation are designed as slide-on slopes (19).

5. Locking element according to Claim 4, characterized in that, following the deflection point which causes a predetermined maximum deflection of the resilient element (resilient rod 7), the eccentric extension (12) merges into an inwardly directed, planar abutment surface (13), which adjoins in the direction of rotation, for the resilient element in the locking position (V).

6. Locking element according to Claim 5, characterized in that the abutment surface (13) for the resilient element (resilient rod 7) is arranged opposite one of the extensions (9) for engaging behind the second part (2), and is delimited by a radially running extension (21), which forms a groove with the extension (9) for engaging behind the second part (2) and has a slide-on slope (22), with the result that the resilient element (7) can also be deflected perpendicularly with respect to the deflecting direction by the eccentric extension (12).

## Revendications

1. Connexion par serrage pour la fixation sans jeu d'un premier élément (1) sur un deuxième élément (2), en particulier d'éléments de boîtiers d'appareils électriques, comprenant un élément de fermeture (3) rotatif pouvant être introduit de l'extérieur dans le premier élément (1) et traversant les deux éléments (1, 2), qui présente deux prolongements (8, 9) se faisant face et s'étendant radialement, destinés à se serrer contre des parties (11) du deuxième élément (2) lors d'un mouvement de rotation de l'élément de fermeture (3) depuis une position de déverrouillage (E) permettant l'introduction, caractérisée par un élément élastique (tige élastique 7) monté sur le deuxième élément (2) et un prolongement d'excentrique (12) monté sur l'élément de fermeture (3) et agissant sur l'élément élastique (7), afin de créer un effort de serrage fixant sans jeu le premier élément (1) sur une butée (20) du deuxième élément (2) dans une position de rotation finale prédéterminée de l'élément de fermeture (3), représentant la position de fermeture (V).

2. Connexion par serrage selon la revendication 1, caractérisée en ce que l'élément élastique est composé d'une tige élastique (7) maintenue aux deux extrémités et déviable par le prolongement d'excentrique (12).

3. Connexion par serrage selon l'une des revendications 1 ou 2, caractérisée en ce que l'angle de rotation entre la position de déverrouillage (E) et la position de fermeture (V) est de 90°.

4. Elément de fermeture pour connexions par serrage selon l'une des revendications 1 à 3, composé d'une pièce circulaire (14) avec un corps creux (10) formé de manière solidaire avec celle-ci et servant de poignée, sur la face extérieure duquel sont formés de manière solidaire les prolongements (8, 9) destinés à se serrer contre le deuxième élément (2) et le prolongement d'excentrique (12), la pièce circulaire (14) comportant une surface de butée (16) de forme circulaire orientée vers le côté extérieur du premier élément (1) et, contiguë à celle-ci vers l'intérieur, une bague de guidage (17), et les prolongements (8, 9) destinés à se serrer contre le deuxième élément (2) formant ensemble avec la face frontale intérieure de la bague de guidage (17), sur la pièce circulaire (14), des rainures, dans lesquelles se glissent les parties (11) à serrer du deuxième élément (2) lors de la rotation de l'élément de fermeture (3) dans la position de fermeture (V), et les parties des faces intérieures des prolongements (8, 9), formant le début des rainures dans le sens de rotation, étant réalisées sous forme de pente de glissement (19).

5. Elément de fermeture selon la revendication 4, caractérisé en ce que le prolongement d'excentrique (12), après franchissement du point de déviation provoquant une déviation maximale prédéterminée de l'élément élastique (tige élastique 7), forme une surface d'appui (13) plane contiguë dans le sens de rotation et orientée vers l'intérieur, destinée à l'élément élastique dans la position de fermeture (V).

6. Elément de fermeture selon la revendication 5, caractérisé en ce que la surface d'appui (13) destinée à l'élément élastique (tige élastique 7) fait face à l'un (9) des prolongements de serrage et est limitée par un prolongement (21) muni d'une pente de glissement (22), s'étendant dans le sens radial et formant une rainure avec le prolongement (9) de serrage, de sorte que l'élément élastique (7) est déviable par le prolongement d'excentrique (12) même verticalement par rapport au sens de déviation.
